(19) Europäisches Patentamt

European Patent Office

Office européen des brevets

(11) **EP 4 715 445 A1**
(12) **EUROPEAN PATENT APPLICATION**
published in accordance with Art. 153(4) EPC

(43) Date of publication:
**25.03.2026 Bulletin 2026/13**

(21) Application number: **24927106.5**

(22) Date of filing: **01.03.2024**

(51) International Patent Classification (IPC):
***G02B 26/10*** *(2006.01)*

(52) Cooperative Patent Classification (CPC):
**G02B 26/10**

(86) International application number:
**PCT/JP2024/007734**

(87) International publication number:
**WO 2025/182066 (04.09.2025 Gazette 2025/36)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Yitoa Aurora Micro Technology
Corporation
Tokyo 164-0001 (JP)**

(72) Inventors:
• **ITO Saburo
Alps-shi, Yamanashi 400-0331 (JP)**
• **AOKI Kenyo
Tokyo 164-0002 (JP)**

(74) Representative: **Keilitz & Partner Patentanwälte
PartGmbB
Triftstraße 5
80538 München (DE)**

(54) **DRIVING DEVICE FOR MOVABLE BODY AND MOVABLE BODY DEFLECTION DEVICE**

(57) The present invention aims to provide a drive device for a movable body capable of reliably reducing the amplitude of the ringing occurring when the swingable movable body is driven. The drive device is for generating a drive signal to drive a movable portion of an actuator having a movable portion fixed to be swingable. The drive device includes a waveform generator circuit and an amplifier. The waveform generator circuit generates a sawtooth signal having a sawtooth waveform of a predetermined frequency, each period of the predetermined frequency including a rising period during which the voltage gradually rises and a falling period during which the voltage gradually falls. The amplifier generates the drive signal by amplifying the sawtooth signal. A voltage change rate of the sawtooth signal within a second section is lower than a voltage change rate of the sawtooth signal within a first section when a shorter one among the rising period and the falling period is divided into the first section and the second section following the first section.

FIG. 2A

EP 4 715 445 A1

**Description**

TECHNICAL FIELD

The present invention relates to a drive device for driving a movable body and a movable body deflection device, particularly a movable body fixed so as to be swingable.

BACKGROUND ART

As a movable body deflection device of this kind, there is known a drive device for driving a Micro Electro Mechanical Systems (MEMS) mirror, and the MEMS mirror includes a mirror portion and is configured to enable the mirror portion to swing in a rotation direction about at least one axis. The drive device causes the mirror portion to swing by supplying a drive signal having, for example, a sawtooth waveform or a rectangular waveform to the MEMS mirror.

However, when a device having resonance characteristics, such as a MEMS mirror, is driven so as to change its amplitude abruptly over a short period of time by a signal having a sawtooth waveform or a rectangular waveform, ringing at the resonance frequency of the MEMS mirror occurs.

Accordingly, a drive device has been proposed that generates a drive signal by combining two identical sawtooth signals serving as sources for the drive signal, the two being mutually phase-shifted by a half period at the resonance frequency, thereby canceling the ringing superimposed on both signals (see, for example, Patent Document 1).

CITED DOCUMENTS

PATENT LITERATURE

Patent Document 1: Japanese Patent No. 5659056

DISCLOSURE OF THE INVENTION

PROBLEMS TO BE SOLVED BY THE INVENTION

Note that the amplitude of the ringing (a high-frequency component) attenuates over time. Therefore, within the half period of the resonance frequency, an amplitude difference arises between the earlier-occurring ringing and the ringing that occurs when the half period of the resonance frequency has elapsed. Consequently, even by combining the two, the ringing could not be completely canceled.

It is therefore an object of the present invention to provide a drive device for a movable body capable of reliably reducing the amplitude of the ringing when the swingable movable body is driven by a drive signal.

SOLUTIONS TO THE PROBLEMS

A drive device for a movable body according to the present invention is a drive device for generating a drive signal to drive an actuator having a movable portion fixed to be swingable to swing the movable portion. The drive device includes a waveform generator circuit and an amplifier. The waveform generator circuit generates a sawtooth signal having a sawtooth waveform of a predetermined frequency, each period of the predetermined frequency including a rising period during which the voltage gradually rises and a falling period during which the voltage gradually falls. The amplifier generates the drive signal by amplifying the sawtooth signal. A voltage change rate of the sawtooth signal within a second section is lower than a voltage change rate of the sawtooth signal within a first section when a shorter one period duration among the rising period and the falling period is divided at a boundary timing into the first section and the second section following the first section.

A movable body deflection device according to the present invention includes a waveform generator circuit, an amplifier, a movable portion, and a drive unit. The waveform generator circuit generates a sawtooth signal having a sawtooth waveform of a predetermined frequency. Each period of the predetermined frequency includes a rising period during which the voltage gradually rises and a falling period during which the voltage gradually falls. The amplifier generates a drive signal by amplifying the sawtooth signal. The movable portion is fixed to be swingable. The drive unit drives the movable portion to swing in response to the drive signal. A voltage change rate of the sawtooth signal within a second section is lower than a voltage change rate of the sawtooth signal within a first section when a shorter one period duration among the rising period and the falling period is divided into the first section and the second section following the first section.

EFFECTS OF THE INVENTION

In the present invention, the shorter of the rising period and the falling period in each period of a sawtooth signal used as the drive signal to swing the movable body is divided into a first section and a subsequent second section following the first section. Then, the voltage change rate within the second section is set lower than the voltage change rate within the first section. Accordingly, the ringing can be reliably reduced.

BRIEF DESCRIPTION OF THE DRAWINGS

FIG. 1 is a diagram illustrating a general configuration of a mirror deflection device 100 as a first embodiment of a movable body deflection device according to the present invention.

FIG. 2A is a waveform diagram illustrating an example of a sawtooth signal generated by a drive device 10.

FIG. 2B is a waveform diagram illustrating another example of a sawtooth signal generated by the drive device 10.

FIG. 3 is a block diagram illustrating an example of an internal configuration of the drive device 10.

FIG. 4 illustrates an example of a memory map for a waveform memory 101.

FIG. 5A is a waveform diagram illustrating sample data d1 to dr included in waveform data WD1 stored in the waveform memory 101 and a waveform of a sawtooth signal WVS for one period.

FIG. 5B is a waveform diagram illustrating the sample data d1 to dr included in waveform data WD2 stored in the waveform memory 101 and a waveform of a sawtooth signal WVS for one period.

FIG. 5C is a waveform diagram illustrating the sample data d1 to dr included in waveform data WD3 stored in the waveform memory 101 and a waveform of a sawtooth signal WVS for one period.

FIG. 6 is a block diagram illustrating another example of the internal configuration of the drive device 10.

FIG. 7 is a diagram illustrating a general configuration of a mirror deflection device 100A as a second embodiment of a movable body deflection device according to the present invention.

FIG. 8 is a block diagram illustrating an example of an internal configuration of a drive device 10A.

FIG. 9 is a flowchart illustrating an initial ringing correction routine.

FIG. 10 is a flowchart illustrating a ringing correction routine.

## DESCRIPTION OF PREFERRED EMBODIMENTS

Hereinafter, embodiments of the present invention will be described in detail with reference to the drawings.

Embodiment 1

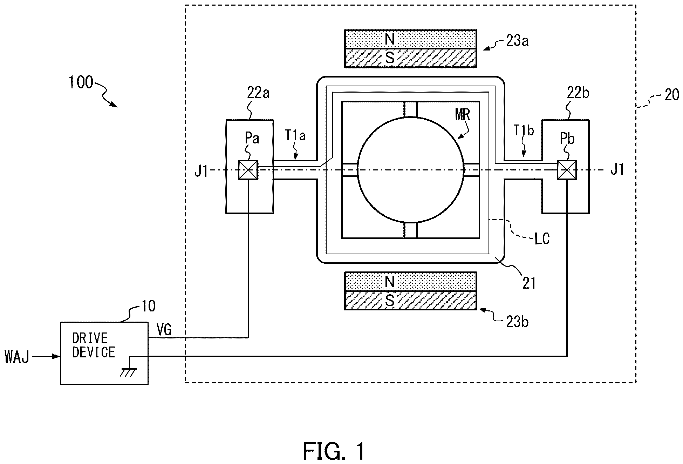

FIG. 1 is a diagram illustrating a general configuration of a mirror deflection device 100 as a first embodiment of a movable body deflection device according to the present invention.

As illustrated in FIG. 1, the mirror deflection device 100 includes a drive device 10 according to the present invention and a Micro Electro Mechanical System (MEMS) mirror 20 serving as an actuator.

The MEMS mirror 20 includes a frame 21 having, at a central portion, a mirror portion MR with a reflective surface, bases 22a and 22b, and magnets 23a and 23b.

Torsion bars T1a and T1b are provided at two opposed locations on the outer periphery of the frame 21, each extending in the direction of axis J1 illustrated in FIG. 1. One ends of the respective torsion bars T1a and T1b are fixed to the respective bases 22a and 22b. The magnets 23a and 23b are respectively disposed at mutually opposed positions along an axis perpendicular to axis J1, with the frame 21 interposed therebetween.

In other words, the mirror portion MR is a movable portion fixed to the bases 22a and 22b via torsion bars T1a and T1b, and is swingable in a rotation direction about axis J1.

A coil LC is disposed on a surface of the frame 21, routed in a loop or spiral along its periphery. One end of the wiring forming the coil LC is connected to the electrode pad Pa provided on the base 22a, and the other end of the wiring is connected to the electrode pad Pb provided on the base 22b.

With this configuration, the drive unit of the MEMS mirror 20, which includes the coil LC and the magnets 23a and 23b, drives the mirror portion MR, serving as the movable portion, to swing in the rotation direction about the axis J1 in response to the drive signal VG supplied to the electrode pads Pa and Pb.

The drive device 10 generates a sawtooth signal with a predetermined frequency having a sawtooth waveform and supplies, as the above-described drive signal VG, an amplified signal thereof to the electrode pads Pa and Pb of the MEMS mirror 20.

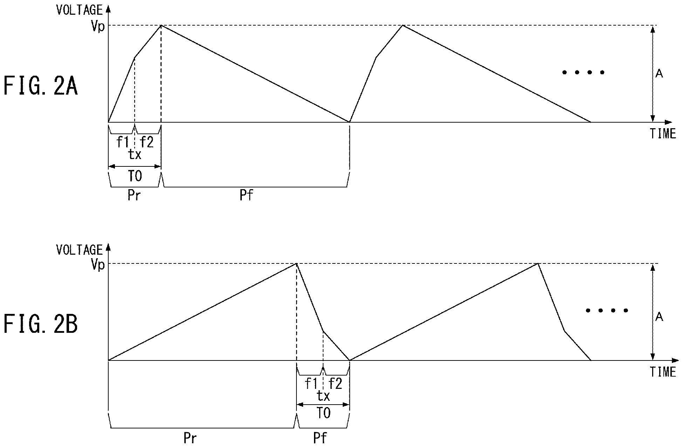

FIG. 2A is a waveform diagram illustrating an example of a sawtooth signal generated by the drive device 10.

As illustrated in FIG. 2A, the sawtooth signal is an oscillating signal having a sawtooth waveform and an amplitude A. Each period includes a rising period Pr, during which the voltage gradually rises, and a falling period Pf, during which the voltage gradually falls.

In the sawtooth signal illustrated in FIG. 2A, the duration of the rising period Pr, during which the voltage gradually rises to the peak voltage Vp, is shorter than that of the falling period Pf, during which the voltage gradually falls from the peak voltage Vp.

In the sawtooth signal illustrated in FIG. 2A, the shorter of the rising period Pr and the falling period Pf, namely, the rising period Pr, has a period duration equal to a period of the resonance frequency (hereinafter, referred to as a resonance period T0) during the swinging of the mirror portion MR.

Furthermore, in the sawtooth signal illustrated in FIG. 2A, when the rising period Pr is divided at a boundary timing tx into a first section f1 and a subsequent second section f2 following the first section f1, the voltage change rate in the second section f2 is set lower than that in the first section f1.

This allows the ringing amplitude during the rising period Pr to be reduced, as compared with the case in which the voltage is uniformly raised to the peak voltage Vp at the voltage change rate of the first section f1.

FIG. 2B is a waveform diagram illustrating another example of a sawtooth signal generated by the

**EP 4 715 445 A1**

drive device 10.

As illustrated in FIG. 2B, the sawtooth signal is an oscillating signal having a sawtooth waveform and the amplitude A, each period of which consists of a rising period Pr, during which the voltage gradually rises, and a falling period Pf, during which the voltage gradually falls.

In this case, in the sawtooth signal illustrated in FIG. 2B, the duration of the rising period Pr, during which the voltage gradually rises to the peak voltage Vp, is longer than that of the falling period Pf, during which the voltage gradually falls from the peak voltage Vp.

In the sawtooth signal illustrated in FIG. 2B, the shorter period duration among the rising period Pr and the falling period Pf (that is, the duration of the falling period Pf) is equal to the resonance period T0 during swinging of the mirror portion MR.

Furthermore, in the sawtooth signal illustrated in FIG. 2B, when the falling period Pf is divided at the boundary timing tx into a first section f1 and a subsequent second section f2 following the first section f1, the voltage change rate in the second section f2 is set lower than that in the first section f1.

This makes it possible to reduce the ringing amplitude within the falling period Pf, compared to the case where the voltage is uniformly decreased at the voltage change rate of the second section f2.

Due to manufacturing variation and the like, the resonance frequency and Q value of the mirror portion MR may vary, and, as a result, the ringing characteristics (frequency, amplitude, and attenuation characteristics) may deviate from the expected condition, which may render the ringing suppression incomplete.

Accordingly, to address this, the drive device 10 includes an adjustment function that, in accordance with the waveform adjustment signal WAJ, adjusts the phase (position) of the boundary timing tx between the first section f1 and the second section f2 illustrated in FIG. 2A or 2B, as well as the voltage change rate for each of the first section f1 and the second section f2.

Accordingly, fine adjustment of the ringing frequency shift due to the variation in the resonance frequency is effected by adjusting the position (phase) of the above-described boundary timing tx. This adjustment of the voltage change rate also compensates for time-dependent changes in the attenuation of the ringing resulting from the above-described variation in the Q value. Furthermore, even if the resonance frequency of the mirror portion MR is an integer multiple of the frequency of the sawtooth signal and the spectrum at the integer multiples of the sawtooth signal is missing due to attenuation associated with the notch characteristic, the linearity of the sawtooth waveform can be maintained by adjusting both the position (phase) of the boundary timing tx and the voltage change rate to generate a resonance spectrum.

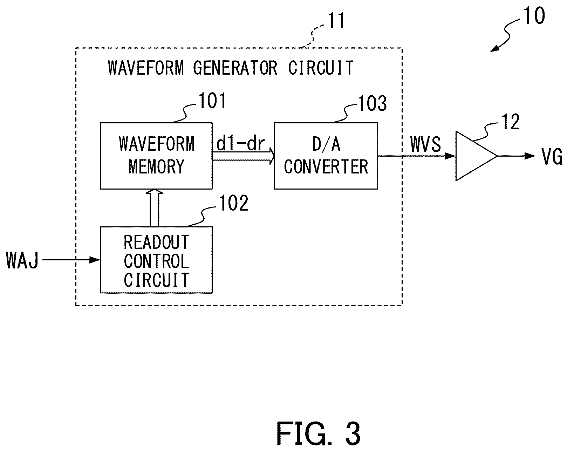

FIG. 3 is a block diagram illustrating an example of the internal configuration of the drive device 10.

In one example illustrated in FIG. 3, the drive device 10 includes a waveform generator circuit 11 and an output amplifier 12.

The waveform generator circuit 11 includes a waveform memory 101, a readout control circuit 102, and a D/A (digital to analog) converter 103.

A plurality of waveform data pieces representing one period of the signal waveform of the sawtooth signal illustrated in FIG. 2A or FIG. 2B are stored in advance in the waveform memory 101.

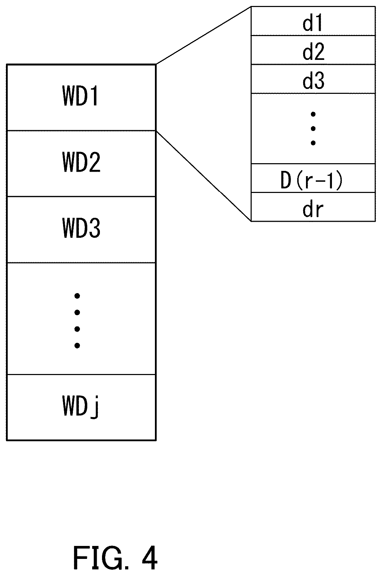

FIG. 4 is a diagram illustrating an overview of a memory map of the waveform memory 101.

As illustrated in FIG. 4, the waveform memory 101 stores waveform data WD1 to WDj, each representing the waveform for one period of the sawtooth signal, with the position (phase) of the boundary timing tx as illustrated in FIG. 2A or 2B and the voltage change rates in the first section f1 and second section f2 varying among the waveforms.

Each of the waveform data WD1 to WDj includes sample data d1 to dr that respectively represent, for example in 8 bits, the sample values obtained when one period of the above sawtooth signal is sampled at a predetermined sampling interval SP to obtain r samples (where r is an integer of 2 or greater).

In this case, the sampling interval SP is 1/n of the resonance period T0 of the mirror portion MR, where n is an integer equal to or more than 2 and denotes the number of samples within the rising period Pr illustrated in FIG. 2A or the falling period Pf illustrated in FIG. 2B.

The readout control circuit 102 receives the waveform adjustment signal WAJ that specifies one of the waveform data WD1 to WDj, and performs readout control on the waveform memory 101 to repeatedly read out the one waveform data piece specified by the waveform adjustment signal WAJ.

In accordance with such readout control, the waveform memory 101 repeatedly reads out the sequence of the sample data d1 to dr contained in one of the waveform data WD1 to WDj. Specifically, the waveform memory 101 repeatedly executes a readout sequence that sequentially reads out each of the sample data d1 to dr at each sampling interval SP, and supplies the resulting sequence of the sample data d1 to dr to a D/A converter 103.

The D/A converter 103 generates the sawtooth signal WVS by converting the sample data d1 to dr read out from the waveform memory 101 into analog voltages corresponding to the sample values indicated by the respective sample data pieces, and supplies the generated sawtooth signal WVS to the output amplifier 12.

The output amplifier 12 supplies, as the drive signal VG, an amplified version of the sawtooth signal WVS to the MEMS mirror 20. The output amplifier 12 may be incorporated into the D/A converter 103.

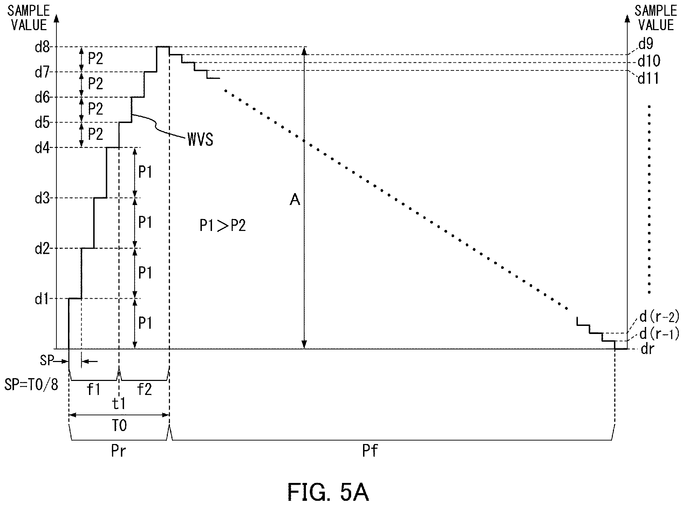

Hereinafter, the generation operation and the adjustment operation of the sawtooth signal WVS by the drive device 10 having the configuration illustrated in FIG. 3 will be described with reference to an example illustrated in FIGS. 5A to 5C.

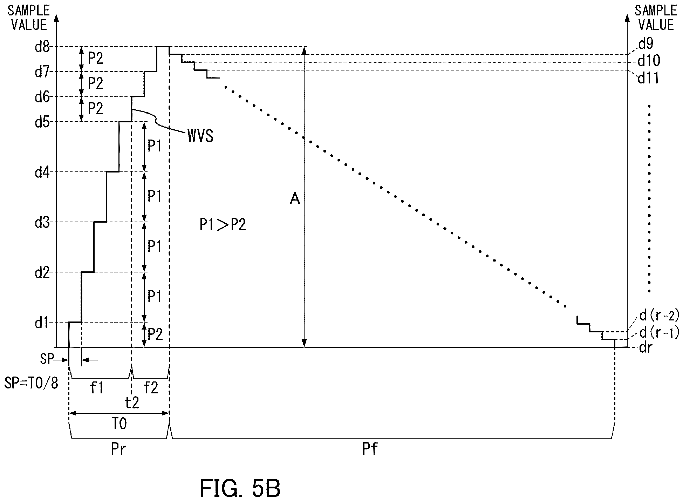

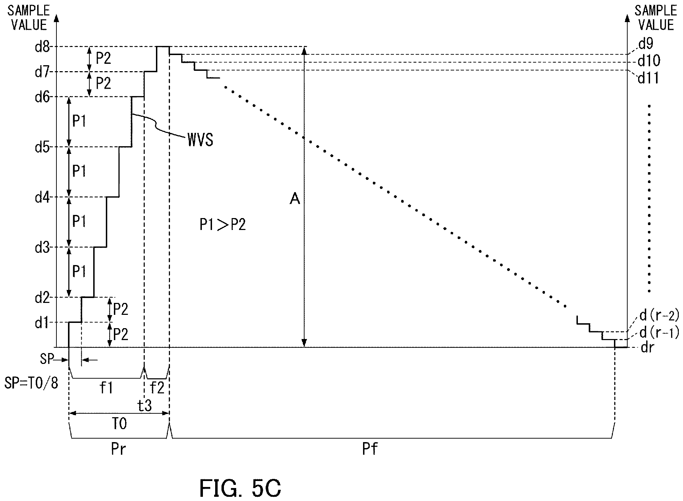

FIGS. 5A, 5B, and 5C are waveform diagrams each illustrating the sample data d1 to dr included in the waveform data WD1, WD2, and WD3, respectively, and the waveform of one period of the sawtooth signal WVS based on the sample data d1 to dr. In FIGS. 5A to 5C, the number of samples n within the rising period Pr is set to 8, and the corresponding sampling interval SP is set to (the resonance period T0/8). In FIGS. 5A to 5C, the form of the sample data d9 to dr in the falling period Pf, and the form of the signal waveform of the sawtooth signal WVS based on that sample data d9 to dr, are the same among the figures.

Here, when the drive device 10 receives, for example, a waveform adjustment signal WAJ that specifies the waveform data WD1, the sample data d1 to dr included in the waveform data WD1 are first read out from the waveform memory 101 and supplied to the D/A converter 103. Accordingly, the drive device 10 outputs a sawtooth signal WVS having a sawtooth waveform corresponding to the sequence of the sample data d1 to dr illustrated in FIG. 5A.

According to the waveform data WD1, as illustrated in FIG. 5A, the rising period Pr is divided at boundary timing t1 into a first section f1 and a second section f2 of equal duration.

Thus, as illustrated in FIG. 5A, the number of sample data pieces in the first section f1 (four pieces, d1 to d4) is equal to the number of sample data pieces in the second section f2 (four pieces, d5 to d8). However, the amplitude difference P2 between adjacent sample data in the sequence of the sample data d4 to d8 is smaller than the amplitude difference P1 between adjacent sample data in the sequence of the sample data d1 to d4.

For example, the amplitude difference P1 is represented by:

$$P1 = (A/8) + \alpha$$

A: amplitude of the sawtooth signal WVS
α: predetermined positive constant, and

the amplitude difference P2 is represented by:

$$P2 = (A/8) - \alpha.$$

Accordingly, in the first section f1 within the rising period Pr of the sawtooth signal WVS generated based on the waveform data WD1, the voltage of the sawtooth signal WVS rises at a voltage change rate of f1:

$$(A + 8\alpha)/T0.$$

In the subsequent second section f2, the voltage of the sawtooth signal WVS rises at a voltage change rate of

f2:

$$(A - 8\alpha)/T0,$$

which is lower than the voltage change rate in the first section f1.

When the drive device 10 receives the waveform adjustment signal WAJ specifying the waveform data WD2, the sample data d1 to dr included in the waveform data WD2 are first read out from the waveform memory 101 and supplied to the D/A converter 103. As a result, the drive device 10 generates a sawtooth signal WVS having a sawtooth waveform corresponding to a sequence of the sample data d1 to dr illustrated in FIG. 5B.

According to the waveform data WD2, as illustrated in FIG. 5B, the rising period Pr is divided, at boundary timing t2 that is one sampling interval SP later than the boundary timing t1 illustrated in FIG. 5A, into a first section f1 and a second section f2 that is shorter than the first section f1.

Thus, as illustrated in FIG. 5B, the number of the sample data pieces in the first section f1 (five pieces, d1 to d5) is greater than that in the second section f2 (three pieces, d6 to d8).

In this case, in the waveform data WD2, the first sample data d1 among the sample data d1 to d5 within the first section f1 has a sample value equal to the above-described amplitude difference P2, and the amplitude difference between adjacent sample data in the sequence of the sample data d1 to d5 is the above-described amplitude difference P1. The amplitude difference between adjacent sample data in the sequence of the sample data d5 to d8 within the second section f2 is the amplitude difference P2 described above.

Therefore, in the first section f1 within the rising period Pr of the sawtooth signal WVS generated based on the waveform data WD2, the voltage of the sawtooth signal WVS rises at a voltage change rate of f1:

$$(A + 4.8\alpha)/T0.$$

In the subsequent second section f2, the voltage of the sawtooth signal WVS rises at a voltage change rate of f2:

$$(A - 8\alpha)/T0,$$

which is lower than the voltage change rate in the first section f1.

In other words, the voltage change rate in the first section f1 illustrated in FIG. 5B is lower than the voltage change rate in the first section f1 illustrated in FIG. 5A. In both FIGS. 5A and 5B, the voltage change rates in the second section f2 are equal. However, since the section duration of the second section f2 in FIG. 5B is shorter than a section duration of the second section f2 in FIG. 5A, the time during which the above voltage change rate (A - 8α)/T0 is maintained is also shorter.

Further, when the drive device 10 receives the waveform adjustment signal WAJ specifying the waveform data WD3, the sample data d1 to dr included in the waveform data WD3 are first read out from the waveform memory 101 and then supplied to the D/A converter 103. As a result, the drive device 10 generates a sawtooth signal WVS having a sawtooth waveform corresponding to a sequence of the sample data d1 to dr illustrated in FIG. 5C.

According to the waveform data WD3, as illustrated in FIG. 5C, the rising period Pr is divided, at boundary timing t3 that is two sampling intervals SP later than the boundary timing t1 illustrated in FIG. 5A, into a first section f1 and a second section f2 that is shorter than the first section f1.

Accordingly, as illustrated in FIG. 5C, the number of the sample data pieces in the first section f1 (six pieces, d1 to d6) is greater than the number of the sample data pieces in the second section f2 (two pieces, d7 and d8).

In this case, in the waveform data WD3, the amplitude difference between adjacent sample data in the sequence of the sample data d1 and d2 among the sample data d1 to d6 within the first section f1 is the above-described amplitude difference P2, and the amplitude difference between adjacent sample data in the sequence of the sample data d2 to d6 is the above-described amplitude difference P1. The amplitude difference between adjacent sample data in the sequence of the sample data d6 to d8 within the second section f2 is the above-described amplitude difference P2.

Accordingly, in the first section f1 within the rising period Pr of the sawtooth signal WVS generated based on the waveform data WD3, the voltage of the sawtooth signal WVS rises at a voltage change rate of f1:

$$(A + 2.66\alpha)/T0.$$

In the second section f2, the voltage of the sawtooth signal WVS rises at a voltage change rate of f2:

$$(A - 8\alpha)/T0,$$

which is lower than the voltage change rate in the first section f1.

In other words, the voltage change rate in the first section f1 illustrated in FIG. 5C is lower than that in the first section f1 illustrated in FIG. 5B. Although the voltage change rates in the second section f2 are equal in both FIGS. 5B and 5C, the second section f2 in FIG. 5C is shorter than the second section f2 in FIG. 5B in the section duration and has also the shorter time during which the above-described voltage change rate (A - 8α)/T0 is maintained.

Thus, in the drive device 10 including the configuration illustrated in FIG. 3, the waveform data WD1 to WDj, which differ in the position of the boundary timing tx at which the voltage change rate is switched within the shorter of the falling period Pf and the rising period Pr, as well as in the voltage change rate in each of the first section f1 and the second section f2, are stored in the waveform memory 101 in advance. The drive device 10 reads out one waveform data piece indicated by the waveform adjustment signal WAJ from among the waveform data WD1 to WDj, and performs D/A conversion thereon to obtain a sawtooth signal WVS in which the position of the boundary timing tx and the respective voltage change rates of the first section f1 and the second section f2 are each adjusted.

This enables a fine adjustment of the ringing frequency shift attributable to a variation in the resonance frequency of the mirror portion MR by adjusting the position (phase) of the boundary timing tx as described above. The adjustment of the voltage change rate compensates for the time-dependent change in the attenuation of the ringing resulting from a variation in the Q value of the mirror portion MR. Furthermore, even if the resonance frequency of the mirror portion MR is an integer multiple of the frequency of the sawtooth signal and the spectrum at integer multiples of the sawtooth signal frequency is missing due to the attenuation associated with the notch characteristic, the linearity of the sawtooth waveform can still be maintained by jointly adjusting the position (phase) of the boundary timing tx and the voltage change rate so as to generate a resonance spectrum.

In the configuration illustrated in FIG. 3, the waveform data WD1 to WDj are prepared in advance with different degrees of adjustment (in terms of the boundary timing tx position and the respective voltage change rates at f1 and f2). However, the drive device 10 may generate the basic waveform data itself, which includes the sample data d1 to dr, and apply adjustments to it based on the waveform adjustment signal WAJ.

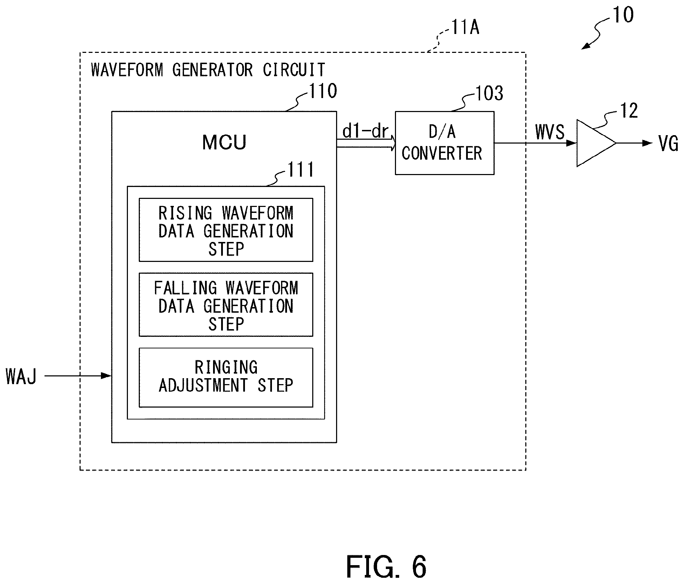

FIG. 6 is a block diagram illustrating an example of another internal configuration of the drive device 10 provided in view of the foregoing.

In the configuration illustrated in FIG. 6, a waveform generator circuit 11A is employed in place of the waveform generator circuit 11 illustrated in FIG. 3.

The waveform generator circuit 11A includes a microcontroller 110 (hereinafter also referred to as "MCU") having a CPU, a memory, and the like; and the D/A converter 103.

The MCU 110 includes a non-volatile memory 111 that stores a waveform data generation program for generating waveform data serving as a basis for the sawtooth signal WVS, as well as basic parameters and the like for generating the sawtooth signal. The basic parameters include frequency, amplitude, the resonance period of the mirror portion MR, the number of samples n, the boundary timing tx, and the respective initial voltage change rates for the first section f1 and the second section f2.

The waveform data generation program includes a rising waveform data generation step, a falling waveform data generation step, and a ringing adjustment step.

By executing the rising waveform data generation step, the MCU 110 generates, based on the above-described basic parameters, for example,

Amplitude: A;
Resonance period: T0;
Number of samples n: 8;
Initial position of boundary timing tx; t1; and
Respective Initial voltage change rates at f1 and f2: Q1 and Q2,

the sequence of the sample data d1 to d8, each consisting of, for example, 8 bits, representing the signal waveform during the rising period Pr in, for example, FIG. 5A.

Next, by executing the falling waveform data generation step, the MCU 110 generates the sequence of sample data d9 to dr (each, for example, 8 bits) representing the signal waveform during the falling period Pf of FIG. 5A, for example.

Next, the MCU 110 performs the ringing adjustment step, in which the sequence of the sample data d1 to d8 generated based on the above-described basic parameters is adjusted in accordance with the waveform adjustment signal WAJ that specifies the position of the boundary timing tx between the first section f1 and the second section f2 and the respective voltage change rates for the first section f1 and the second section f2. For example, when the MCU 110 receives a waveform adjustment signal WAJ that specifies the boundary timing t2 as illustrated in FIG. 5B and the voltage change rate for each of the first section f1 and the second section f2, the MCU 110 performs an adjustment to change the sample data d1 to d8 illustrated in FIG. 5A, which was generated based on the above-described basic parameters, into the form of the sample data d1 to d8 illustrated in FIG. 5B.

The MCU 110 then supplies the D/A converter 103 with a sequence obtained by concatenating the adjusted sequence of the sample data d1 to d8 with the sequence of the sample data d9 to dr generated based on the basic parameters.

The D/A converter 103 and the output amplifier 12 are the same as those illustrated in FIG. 3. Therefore, a description thereof is omitted.

Embodiment 2

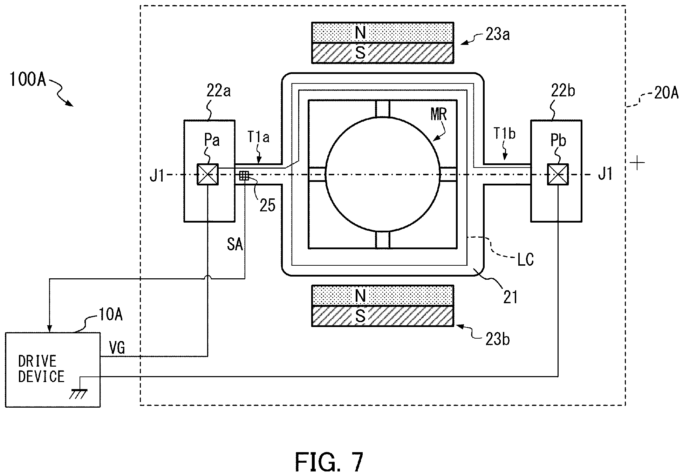

FIG. 7 is a diagram illustrating a general configuration of a mirror deflection device 100A as a second embodiment of a movable body deflection device according to the present invention.

The mirror deflection device 100A illustrated in FIG. 7 includes a drive device 10A according to the present invention and a MEMS mirror 20A serving as an actuator.

Except for a newly provided deflection angle sensor 25, the configuration of the MEMS mirror 20A is the same as the one illustrated in FIG. 1. Accordingly, a description of the other configuration is omitted.

The deflection angle sensor 25 is, for example, a piezoelectric sensor and is disposed on a surface of the torsion bar T1a. The deflection angle sensor 25 detects a deflection angle of the mirror portion MR when it swings about the axis J1 and supplies a deflection angle detection signal SA indicating the deflection angle to the drive device 10A.

Similar to the drive device 10 illustrated in FIG. 1, the drive device 10A generates the sawtooth signal WVS having the sawtooth waveform illustrated in FIG. 2A or 2B, and supplies, as the drive signal VG, an amplified version thereof to the electrode pads Pa and Pb of the MEMS mirror 20A.

Accordingly, in the drive device 10A, as in the drive device 10, when generating the sawtooth signal, the shorter of the rising period and the falling period of the voltage is divided at the boundary timing tx into a first section f1 and a second section f2, and the ringing is suppressed by setting the voltage change rate in the latter second section f2 lower than that in the first section f1.

Furthermore, the drive device 10A includes a self-correction function that, based on the deflection angle detection signal SA supplied from the deflection angle sensor 25, adjusts the ringing suppression to an optimal state rather than adjusting the ringing in accordance with an externally supplied waveform adjustment signal WAJ.

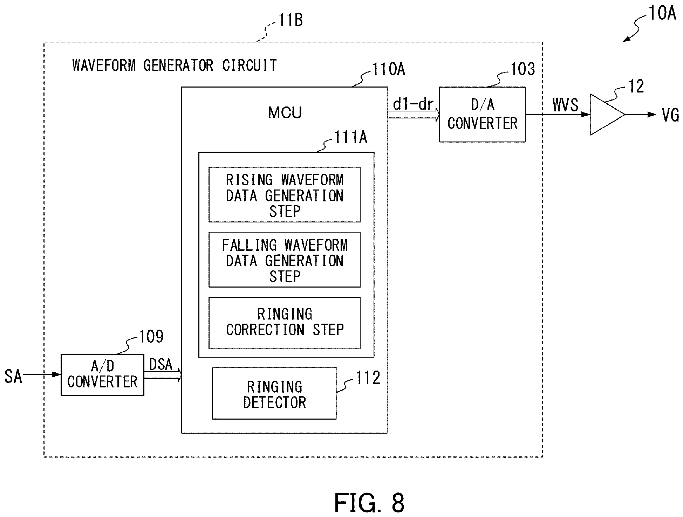

FIG. 8 is a block diagram illustrating an example of an internal configuration of the drive device 10A.

As illustrated in FIG. 8, the drive device 10A employs a waveform generator circuit 11B in place of the waveform generator circuit 11A illustrated in FIG. 6.

The waveform generator circuit 11B includes an A/D converter 109, a microcontroller (MCU) 110A, and the D/A converter 103.

The A/D converter 109 converts the deflection angle, represented by an analog voltage value in the deflection angle detection signal SA supplied from the deflection angle sensor 25, into a deflection angle data signal DSA represented in digital form, and supplies the deflection angle data signal DSA to an MCU 110A.

The MCU 110A includes a non-volatile memory 111A that stores a waveform data generation program for generating waveform data serving as a basis for a sawtooth signal, and basic parameters and the like for generating the sawtooth signal, and a ringing detector 112.

Note that the basic parameters include the frequency, the amplitude, the resonance period of the mirror portion MR, the number of samples n, the boundary timing tx, and the initial voltage change rate for each of the first section f1 and the second section f2. Further, the waveform data generation program includes a rising waveform data generation step, a falling waveform data generation step, and a ringing correction step.

The ringing detector 112 includes, for example, a frequency analyzer configured to perform a fast Fourier transform (FFT). Based on the deflection angle data signal DSA, and the ringing detector 112 detects the ringing and generates ringing information representing the frequency and amplitude of the detected ringing.

The MCU 110A executes, in accordance with the waveform data generation program stored in the memory 111A, the rising waveform data generation step, the falling waveform data generation step, and the ringing correction step.

The operations executed by the MCU 110A in the rising waveform data generation step, the falling waveform data generation step, and the ringing correction step will be described below, assuming that the drive device 10A generates the drive signal VG illustrated in FIG. 2A.

First, by executing the rising waveform data generation step, the MCU 110A generates, based on the basic parameters described above, for example,

> Amplitude: A;
> Resonance period: T0;
> Number of samples n: 8;
> Initial position of boundary timing tx: t1; and
> Respective Initial voltage change rates at f1 and f2: Q1 and Q2,

the sequence of the sample data d1 to d8, each consisting of, for example, 8 bits, representing the signal waveform during the rising period Pr of FIG. 5A.

Next, the MCU 110A executes the falling waveform data generation step to generate the sequence of the sample data d9 to dr representing the signal waveform during the falling period Pf illustrated in FIG. 5A, each sample consisting of, for example, 8 bits.

Next, the MCU 110A performs the ringing correction step.

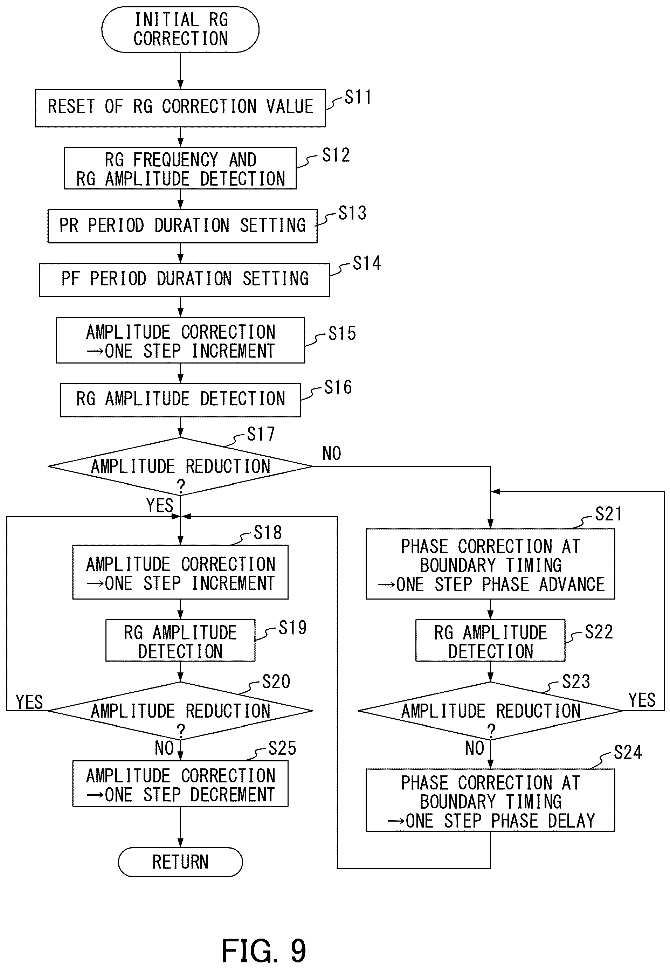

In the ringing correction step, the MCU 110A first performs processing in accordance with the initial correction routine for ringing (hereinafter, also referred to as RG) illustrated in FIG. 9.

That is, in the RG initial correction process, the MCU 110A first resets the correction values (the amplitude and the phase) for ringing correction to predetermined initial values (Step S11).

Next, the MCU 110A sets the frequency and amplitude of the currently occurring ringing in an internal register (not illustrated) by acquiring the ringing information generated by the ringing detector 112 (Step S12).

Next, since the period corresponding to the above-described ringing frequency is the resonance period T0 of the mirror portion MR, the MCU 110A sets the period duration of the rising period Pr to this value (Step S13).

The MCU 110A then sets the period duration of the falling period Pf by subtracting the period duration of the rising period Pr from the duration of one period of the sawtooth signal.

Next, the MCU 110A, corrects the magnitude of the amplitude difference P1 for each of the sample data d1 to d4 in the first section f1, for example, illustrated in FIG. 5A, to a larger value by one step (a predetermined amount), and corrects the amplitude difference P2 (where P1 > P2) for each of the sample data d5 to d8 in the second section f2 to a smaller value by one step (a predetermined amount) (Step S15). Accordingly, the MEMS mirror 20A is driven by the drive signal VG generated in accordance with the sequence of the sample data d1 to dr, which includes the corrected sample data d1 to d8. In this case, the ringing detector 112 generates the ringing information indicating the frequency and the amplitude of the ringing detected during such a drive condition.

Here, the MCU 110A detects the amplitude of the currently occurring ringing by acquiring the ringing information generated by the ringing detector 112 (Step S16).

Next, the MCU 110A determines whether the amplitude of the ringing detected in Step S16 is less than the amplitude of the ringing acquired in Step S12 (Step S17).

If it is determined in Step S17 that an amplitude reduction has occurred, the MCU 110A corrects the magnitude of the amplitude difference P1 at the current time for each of the sample data d1 to d4 in the first section f1 to a larger value by one step (the predetermined amount), and corrects the amplitude difference P2 for each of the sample data d5 to d8 in the second section f2 to a smaller value by one step (the predetermined amount) (Step S18). Accordingly, the MEMS mirror 20A is driven by the drive signal VG generated in accordance with the sequence of the sample data d1 to dr, which includes the sample data d1 to d8 to which the correction has been applied. In this case, the ringing detector 112 generates the ringing information indicating the frequency and the amplitude of the ringing detected under such a driving condition.

Here, the MCU 110A detects the amplitude of the currently occurring ringing by acquiring the ringing information generated by the ringing detector 112 (Step S19).

Next, the MCU 110A determines whether the amplitude of the ringing detected in Step S19 is less than the previously obtained ringing amplitude (Step S20). If it is determined in Step S20 that there has been a decrease, the MCU 110A returns to execution of Step S18 and again performs the series of operations in Steps S18 to S20.

Further, in the above-described Step S17, if it is determined that the amplitude of the ringing detected in Step S16 has not decreased relative to the amplitude of the previously acquired ringing, the MCU 110A performs phase correction by advancing the boundary timing tx between the first section f1 and the second section f2 by one step, that is, by one sampling interval (Step S21). Accordingly, the number of sampling data pieces included in the first section f1, each having an amplitude difference of P1, increases by one, while the number of sampling data pieces included in the second section f2, each having an amplitude difference of P2, decreases by one. Accordingly, the MEMS mirror 20A is driven by the drive signal VG generated in accordance with the sequence of the sample data d1 to dr that includes the sample data d1 to d8 to which the correction has been applied. In this case, the ringing detector 112 generates the ringing information indicating the frequency and the amplitude of the ringing detected during such a drive condition.

Here, the MCU 110A detects the amplitude of the currently occurring ringing by acquiring the ringing information generated by the ringing detector 112 (Step S22).

Next, the MCU 110A determines whether the amplitude of the ringing detected in Step S22 is less than the previously acquired ringing amplitude (Step S23). If it is determined in Step S23 that a decrease has occurred, the MCU 110A returns to Step S21 and repeats the series of operations of Steps S21 to S23.

On the other hand, if it is determined in Step S23 that no decrease has occurred, the MCU 110A corrects the boundary timing tx between the first section f1 and the second section f2 such that its phase is delayed by one step, that is, by one sampling interval (Step S24). As a result, the number of sampling data pieces in the first section f1, each having an amplitude difference P1, decreases by one, while the number of sampling data pieces in the second section f2, each having an amplitude difference P2, increases by one.

After Step S24, the MCU 110A proceeds to execute the above-described Step S18 and again performs the series of operations of Steps S18 to S20 previously described.

During this time, if it is determined in Step S20 that the amplitude of the ringing detected in Step S19 has not decreased relative to the previously acquired ringing amplitude, the MCU 110A corrects, by one step (the predetermined amount), the magnitude of the amplitude difference P1 to a smaller value for each of the sample data d1 to d4 of the first section f1 at the current time, and corrects, by one step (the predetermined amount), the amplitude difference P2 to a larger value for each of the sample data d5 to d8 of the second section f2 (Step S25).

At this time, by executing Step S25, it is corrected to a state in which the ringing is suppressed to the maximum extent.

Accordingly, after executing Step S25, the MCU 110A exits the RG initial correction routine illustrated in FIG. 9 and resumes execution of the main routine (not described herein).

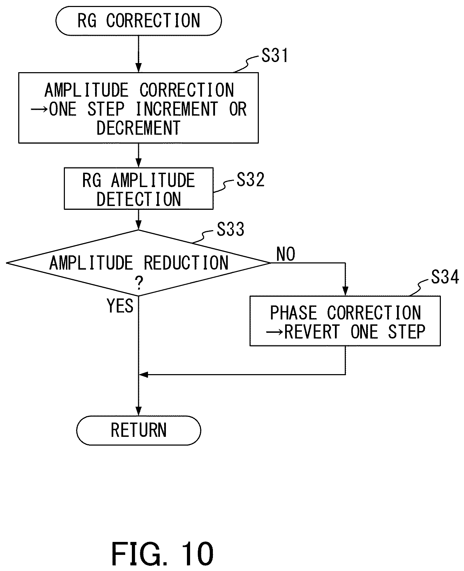

During execution of the main routine, the MCU 110A executes the RG correction routine illustrated in FIG. 10 at predetermined intervals.

First, the MCU 110A corrects, for the current first section f1, the magnitude of the amplitude difference P1 corresponding to each of the sample data d1 to d4 by one step (the predetermined amount) to a larger (or smaller) value, and also corrects, for the second section f2, the amplitude difference P2 corresponding to each of the sample data d5 to d8 by one step (the predetermined amount) to a larger (or smaller) value (Step S31). Accordingly, the MEMS mirror 20A is driven by the drive signal VG generated based on the sequence of the sample data d1 to dr, which includes the sample data d1 to d8 with the correction applied. At this time, the ringing detector 112 generates the ringing information indicating the frequency and the amplitude of the ringing detected under such a driving condition.

Here, the MCU 110A detects the amplitude of the currently occurring ringing by acquiring the ringing information generated by the ringing detector 112 (Step S32).

Next, the MCU 110A determines whether the ringing amplitude detected in Step S32 is less than the previously obtained ringing amplitude (Step S33). If it is determined in Step S33 that no decrease has occurred, the MCU 110A performs phase correction to shift the boundary timing tx between the first section f1 and the second section f2 to its previous state by one step (Step S34).

After executing Step S34, or if it is determined in Step S33 that the amplitude of the ringing has decreased, the MCU 110A exits this RG correction routine and returns to executing the main routine (not described), since the ringing has been suppressed to the maximum extent possible.

The MCU 110A then supplies the D/A converter 103 with a sequence obtained by concatenating the sequence of the sample data d1 to d8, which have been corrected as described above, with the sequence of the sample data d9 to dr generated by the falling waveform data generation step.

The D/A converter 103 generates the sawtooth signal WVS by converting each of the sample data d1 to dr into an analog voltage corresponding to the sample value indicated by the corresponding sample data piece, and supplies the generated sawtooth signal to the output amplifier 12.

The output amplifier 12 supplies an amplified signal of the sawtooth signal WVS as the drive signal VG to the MEMS mirror 20A.

Thus, in the drive device 10A illustrated in FIG. 8, as in the drive device 10 illustrated in FIG. 3 or FIG. 6, the shorter one of the rising period Pr and the falling period Pf of the sawtooth signal voltage is divided at boundary timing tx into the first section f1 and the second section f2, and the ringing is suppressed by setting the voltage change rate in the latter, the second section f2 to be lower than that in the first section f1.

In other words, a drive device (10) that generates a drive signal (VG) to drive a movable portion (MR) of an actuator (20) to swing, in which the movable portion is swingably supported, may simply include the following waveform generator circuit and an amplifier.

First, when generating the drive signal having the sawtooth waveform as illustrated in FIG. 2A, the waveform generator circuits (11, 11A, 11B) generate the sawtooth signal (WVS) having a sawtooth waveform of the predetermined frequency, each period includes a rising period (Pr) during which the voltage gradually rises and a falling period (Pf) during which the voltage gradually falls. The amplifier (12) outputs, as the drive signal (VG), an amplified version of the sawtooth signal. In this case, in the sawtooth signal generated by the waveform generator circuit, for the shorter one of the rising period (Pr) and the falling period (Pf), namely, the rising period, when the rising period is divided into a first section (f1) and a second section (f2) that follows the first section, the voltage change rate of the sawtooth signal within the second section (f2) is lower than the voltage change rate within the first section (f1).

When generating the drive signal having the sawtooth waveform illustrated in FIG. 2B, the waveform generator circuits (11, 11A, 11B) generate the sawtooth signal (WVS) having a sawtooth waveform of the predetermined frequency, each period includes a rising period (Pr) during which the voltage gradually rises and a falling period (Pf) during which the voltage gradually falls. The amplifier (12) outputs, as the drive signal (VG), an amplified version of the sawtooth signal. In this case, for the sawtooth signal generated by the waveform generator circuit, the shorter of the falling period (Pf) and the rising period (Pr), namely, the falling period (Pf) is divided into a first section (f1) and a second section (f2) that follows the first section, and the voltage change rate of the sawtooth signal within the second section (f2) is lower than the voltage change rate within the first section (f1).

DESCRIPTION OF REFERENCE SIGNS

10, 10A Drive device
11, 11A Waveform generator circuit
20, 20A MEMS mirror
101 Waveform memory
103 D/A converter
110, 110A Microcontroller

**Claims**

1. A drive device for generating a drive signal to drive an actuator having a movable portion fixed to be swingable to swing the movable portion, the drive device comprising:

   a waveform generator circuit that generates a sawtooth signal having a sawtooth waveform of a predetermined frequency, each period of the predetermined frequency including a rising period during which the voltage gradually rises and a falling period during which the voltage gradually falls; and
   an amplifier that generates the drive signal by amplifying the sawtooth signal, wherein a voltage change rate of the sawtooth signal within a second section is lower than a voltage change rate of the sawtooth signal within a first section when one period having a shorter duration among the rising period and the falling period is divided into the first section and the second section following the first section.

2. The drive device according to claim 1, wherein the one period has a period duration equal to a resonance period of the actuator.

3. The drive device according to claim 1, wherein

   the waveform generator circuit includes a D/A converter that receives waveform data including a sequence of a plurality of sample data pieces and generates the sawtooth signal by converting each of the sample data pieces into an analog signal at predetermined sampling intervals, and
   the predetermined sampling interval is expressed as 1/n of the resonance period of the actuator (where n is a number of samples in the one period).

4. The drive device according to any one of claims 1 to 3, wherein
   the waveform generator circuit receives a waveform adjustment signal and has an adjustment function that adjusts the voltage change rate in the first section and the voltage change rate in the second section according to the waveform adjustment signal.

5. The drive device according to claim 4, wherein the first section and the second section have an equal duration.

6. The drive device according to claim 4, wherein the waveform generator circuit has an adjustment function that adjusts a phase at a boundary timing between the first section and the second section within the one period according to the waveform adjustment signal.

7. The drive device according to any one of claims 1 to 3, comprising

a deflection angle sensor that detects a deflection angle of the swing of the movable portion and generates a deflection angle detection signal indicating the deflection angle, wherein the waveform generator circuit includes a ringing correction unit that detects an amplitude of a ringing occurring in the sawtooth signal in response to the deflection angle detection signal and adjusts the voltage change rate in the first section and the voltage change rate in the second section or the phase at the boundary timing between the first section and the second section within the one period to reduce the amplitude of the ringing.

8. A movable body deflection device comprising:

a waveform generator circuit that generates a sawtooth signal having a sawtooth waveform of a predetermined frequency, each period of the predetermined frequency including a rising period during which the voltage gradually rises and a falling period during which the voltage gradually falls;
an amplifier that generates a drive signal by amplifying the sawtooth signal;
an actuator having a movable portion fixed to be swingable; and
a drive unit that drives the movable portion to swing in response to the drive signal, wherein a voltage change rate of the sawtooth signal within a second section is lower than a voltage change rate of the sawtooth signal within a first section when one period having a shorter duration among the rising period and the falling period is divided into the first section and the second section following the first section.

FIG. 1

FIG. 2A

FIG. 2B

11

10

WAVEFORM GENERATOR CIRCUIT

101

WAVEFORM MEMORY

d1-dr

103

D/A CONVERTER

WVS

12

VG

102

WAJ → READOUT CONTROL CIRCUIT

FIG. 3

| | |
|---|---|
| WD1 | d1 |
| | d2 |
| | d3 |
| WD2 | • • • |
| WD3 | D (r-1) |
| | dr |
| • • • | |
| WDj | |

## FIG. 4

FIG. 5A

FIG. 5B

FIG. 5C

WAVEFORM GENERATOR CIRCUIT 11A

10

110

MCU

d1-dr

103

D/A CONVERTER

WVS

12

VG

111

RISING WAVEFORM DATA GENERATION STEP

FALLING WAVEFORM DATA GENERATION STEP

WAJ

RINGING ADJUSTMENT STEP

FIG. 6

FIG. 7

FIG. 8

FIG. 9

RG CORRECTION

S31

AMPLITUDE CORRECTION
→ONE STEP INCREMENT OR
DECREMENT

RG AMPLITUDE
DETECTION    S32

S33

AMPLITUDE REDUCTION
?

NO

YES

S34

PHASE CORRECTION
→REVERT ONE STEP

RETURN

FIG. 10

## INTERNATIONAL SEARCH REPORT

International application No.

**PCT/JP2024/007734**

### A. CLASSIFICATION OF SUBJECT MATTER

***G02B 26/10***(2006.01)i

FI: G02B26/10 104Z

According to International Patent Classification (IPC) or to both national classification and IPC

### B. FIELDS SEARCHED

Minimum documentation searched (classification system followed by classification symbols)

G02B26/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2019-191226 A (MITSUMI ELECTRIC CO., LTD.) 31 October 2019 (2019-10-31) paragraphs [0041]-[0066], fig. 1, 7-9 | 1-3, 8 |
| Y | JP 2017-129882 A (PIONEER CORPORATION) 27 July 2017 (2017-07-27) paragraphs [0047]-[0065], fig. 2, 3 | 1-3, 8 |
| A | JP 2016-145926 A (NIPPON SEIKI CO., LTD.) 12 August 2016 (2016-08-12) entire text, all drawings | 1-8 |

☐ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 April 2024** | **23 April 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/007734**

| Patent document cited in search report | | | Publication date (day/month/year) | Patent family member(s) | | | Publication date (day/month/year) |
|---|---|---|---|---|---|---|---|
| JP | 2019-191226 | A | 31 October 2019 | US 2019/0324264 A1 paragraphs [0051]-[0076], fig. 1, 7-9 CN 110389443 A | | | |
| JP | 2017-129882 | A | 27 July 2017 | (Family: none) | | | |
| JP | 2016-145926 | A | 12 August 2016 | US 2018/0024356 A1 entire text, all drawings WO 2016/129186 A1 EP 3258304 A1 | | | |

Form PCT/ISA/210 (patent family annex) (July 2022)

**EP 4 715 445 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5659056 B